# EUROPEAN PATENT SPECIFICATION

(11) **EP 0 398 364 B1**
(45) Date of publication and mention of the grant of the patent: **14.08.1996**
(21) Application number: 90109475.5
(22) Date of filing: 18.05.1990
(51) Int. Cl.: H01L 49/02, H01C 7/00

(54) **Thick-film element having flattened resistor layer**
Dickschicht-Element mit abgeflachter Widerstandsschicht
Elément à couche épaisse comportant une couche de résistance aplatie

(30) Priority: 18.05.1989 JP 124670/89
(43) Date of publication of application: 22.11.1990
(73) Proprietor: KABUSHIKI KAISHA TOSHIBA, Kawasaki-shi, Kanagawa-ken 210 (JP)
(72) Inventor: Nii, Minoru, c/o Intellectual Property Div., Tokyo 105 (JP); Fukuoka, Yoshitaka, c/o Intellectual Property Div., Tokyo 105 (JP)
(74) Representative: Lehn, Werner, Dipl.-Ing.

(56) References cited:
- EP-A- 0 021 833
- DD-A- 206 601
- PATENT ABSTRACTS OF JAPAN vol. 3, no. 70 (E-117) 16 June 1979 & JP-A-54 047 664
- Horst Völz: "Elektronik" 1986, Akademie Verlag, Berlin, GRD, pages 964-965 and 968-979

## Description

The present invention relates to a method of making a thick-film element and, more particularly, to making a thick-film element having an improved resistance precision.

A thick-film element is generally a circuit element obtained by printing a conductor material or resistor material on an insulating substrate by screen printing and baking the resultant structure to form the element by adhesion. A typical example of the thick-film element is a thick-film resistor element. For example, a conductive paste (e.g., gold: to be abbreviated to as Au hereinafter) having a film thickness of 10 µm or more is screen-printed at a plurality of pairs of spots on one major surface of an alumina substrate by using a screen mask, and the conductive paste is baked to form electrode layers by adhesion. A paste-like resistor material (e.g., Ruthenium Oxide: to be abbreviated to as RuO₂ hereinafter) is printed so that two end portions of the material overlap the electrode layers and is baked to form resistor layers by adhesion. Thereafter, trimming is performed to remove a part of each resistor layer by using a laser or the like so as to physically change the shape of the resistor layer, thereby adjusting a resistance of the layer.

As, however, a thick-film element having the above structure is integrated and miniaturized, a resistance precision of the resistor layer is degraded upon baking.

Furthermore, the necessary trimming, which must be performed on a large scale, can lead to a reduction in manufacturing yield, as will now be explained.

That is, the resistor layer is printed by using a screen mask so that its two end portions overlap corresponding electrodes. Therefore, the film thickness of a central portion of the resistor layer is smaller than that of each end portion, and the resistor layer having this shape is directly baked to form a thick-film resistor element. As a result, the shape of the resistor layer is distorted, increasing the difference between the actual resistance of the manufactured resistor element and its resistance.

As this difference increases, so the amount of resistor layer to be trimmed to adjust the resistance increases. Therefore, a current applied to the element is concentrated in the trimmed portion of the resistor layer. As a result, since especially electrical characteristics (e.g., a maximum withstand voltage) do not satisfy specifications, manufacturing yield is reduced.

It is, therefore, an object of the present invention to provide a method of making thick-film element which increases a resistance precision of an electrical resistor layer formed by adhesion and can be used without performing trimming.

A method of making a thick-film resistor element having a flattened resistor layer by CVD or sputtering is known from JP-A-54 047 664.

According to the invention, there is provided in common with EP-A-0 021 833, a method of making a thick-film element, comprising forming, on a flat major surface of an insulating substrate by adhesion using screen printing, firstly a plurality of electrodes, constituted by at least a pair of spaced-apart conductors and then at least one electrical resistor layer, the or each of which extends across from one conductor to the other one, and is electrically connected to said conductors.

According to the invention there is provided a method as set out in claim 1.

This invention can be more fully understood from the following detailed description when taken into conjunction with the accompanying drawings, in which:

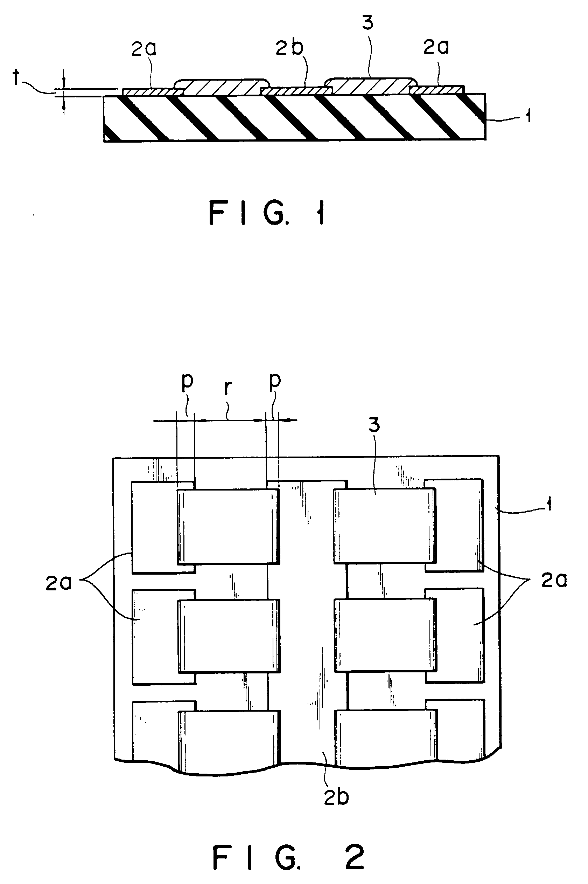

Fig. 1 is a sectional view showing a structure of an embodiment of a thick-film element according to the present invention; and
Fig. 2 is a top view showing the thick-film element of the present invention shown in Fig. 1.

For example, an alumina substrate belonging to a ceramic insulating substrate is used as an insulating substrate. A conductive paste (e.g., Au) is screen-printed to form an array on one major surface of an alumina substrate 1 by using a screen mask having a thickness of 5 µm or less. The conductive paste is dried as needed and baked to form electrode layers 2a and 2b on the major surface of the substrate 1. In particular, the film thickness of the screen-printed conductive paste is set such that the film thickness of the baked electrode layers 2a and 2b constantly becomes 5 µm or less. This is because if the film thickness of the layers 2a and 2b exceeds 5 pm, flattening of a sectional shape of a resistor layer (to be described later) cannot be performed. It is a matter of course that flattening is not limited by an interelectrode distance orthe size of the electrode layer.

A paste-like resistor material (e.g., RuO₂) is screen-printed such that two sides of each material piece are electrically connected to corresponding electrode layers 2a and 2b. If necessary, the alumina substrate is placed in a heated atmosphere to dry the resistor material.

The alumina substrate 1 dried as needed is placed in a high-temperature atmosphere to bake the resistor material. As a result, resistor layers 3 are formed on the substrate 1.

Actually, each resistor layer is formed to have a predetermined thickness so that a resistance of 5 to 100 kΩ is obtained in accordance with applications. For example, a screen mask (not shown) having a thickness of 3 µm an interelectrode distance r of 0.5 mm is manufactured. By using this screen mask, a conductive paste pattern containing Au as a base is printed to have a thickness of about 3 µm or more on the major surface of the substrate 1 and baked to form the Au electrode layers 2a and 2b having a thickness of about 4 µm.

The RuO₂ resistor material is screen-printed on the electrode layers 2a and 2b so that two end portions each of material piece overlap corresponding electrode layers a small distance p of about 0.1 mm (an overlap width). If necessary, the alumina substrate 1 is placed in an atmosphere at, e.g., 120°C to dry the resistor material. After drying, the substrate 1 is placed in an atmosphere at, e.g., 850°C for 30 minutes to bake the resistor material, thereby forming the resistor layers 3.

In the thick-film resistor element actually manufactured as described above, the resistor layers 3 have almost no variations in film thickness, have good shape reproducibility, and are flattened. For this reason, it is expected that resistor layers having a resistance precision obtained upon baking falling within the range of ±20% with respect to a designed value occupy 95% or more of the total resistor layers without performing trimming. Therefore, this thick-film resistor element can be put into practical use without performing trimming provided that it is used under normal conditions. Omission of trimming from a manufacturing process is effective because the process is simplified and a manufacturing cost is reduced.

If trimming is performed for the above thick-film element, the resistance precision is further improved. In addition, since an amount of the resistor layer to be trimmed is decreased to be smaller than that of a conventional structure, a reduction in allowance of a current or the like can be prevented.

This thick-film resistor element can be easily used as an element for a rectangular plate type chip resistor, a network resistor, or the like and can be satisfactorily used as a pull-up resistor of a digital circuit without performing trimming. Although the insulating substrate is disclosed as an alumina substrate belonging to a ceramic insulating substrate, it may be a glass substrate.

In the above embodiment, the present invention is disclosed as a thick-film resistor element. The present invention, however, is not limited to the above embodiment, but a high-precision resistor layer can be assembled as a circuit element in a thick-film IC or in the thick-film portion of a hybrid IC also including a thin-film circuit element.

Reference signs in the claims are intended for better understanding and shall not limit the scope of the claims.

## Claims

1. A method of making a thick-film element, comprising forming, on a flat major surface of an insulating substrate (1) by adhesion using screen printing, firstly a plurality of electrodes, constituted by at least a pair of spaced-apart conductors (2a, 2b), and then at least one electrical resistor layer (3), the or each of which extends across from one conductor (2a) to the other one (2b), and is electrically connected to said conductors (2a, 2b), characterised in that end portions of said electrical resistor layer (3) respectively overlap said conductors (2a, 2b) by a distance (p) of about 0.1 mm and said conductors (2a, 2b) have a thickness of not more than 5 µm, so that the surfaces of said conductors (2a, 2b) and said electrical resistor layer (3), including the overlapping end portions of the electrical resistor layer, are flat.

2. A method according to claim 1, wherein a plurality of said pairs of conductors (2a, 2b) are formed by adhesion in a matrix manner, and said flat electrical resistor layer (3) is one of a plurality of such layers, each electrically connected to the conductors of a respective conductor pair (2a, 2b).

3. A method according to claim 1 or 2, wherein said insulating substrate (1) is a ceramic substrate.

4. A method according to claim 1 or 2, wherein said insulating substrate (1) is an alumina substrate.

5. A method according to claim 1 or 2, wherein said insulating substrate (1) is a glass substrate.

## Patentansprüche

1. Verfahren zum Herstellen eines Dickfilmelementes, das auf einer flachen, größeren Oberfläche eines isolierenden Substrates das Ausbilden erstens einer Vielzahl von Elektroden, die aus mindestens einem Paar beabstandeter Leiter (2a, 2b) bestehen, und daraufhin mindestens einer elektrischen Widerstandsschicht (3) durch Adhäsion unter Benutzung des Siebdruckes umfaßt, wobei sich die Schicht bzw. jede Schicht von einem Leiter (2a) zum anderen Leiter (2b) hin erstreckt und elektrisch an die genannten Leiter (2a, 2b) angeschlossen ist,
dadurch **gekennzeichnet,** daß
Endabschnitte der elektrischen Widerstandsschicht (3) jeweils die genannten Leiter (2a, 2b) um einen Abstand (p) von etwa 0,1 mm überlappen, und daß die Leiter (2a, 2b) eine Dicke von nicht mehr als 5 um besitzen, so daß die Oberflächen der Leiter (2a, 2b) und die elektrische Widerstandsschicht (3) einschließlich der überlappenden Endabschnitte der elektrischen Widerstandsschicht flach sind.

2. Verfahren nach Anspruch 1, bei dem eine Vielzahl der genannten Paare von Leitern (2a, 2b) durch Adhäsion in Matrixform ausgebildet sind, und daß die genannte flache elektrische Widerstandsschicht (3) eine Schicht in einer Vielzahl solcher Schichten ist, von denen jede an die Leiter eines entsprechenden Leiterpaares (2a, 2b) elektrisch angeschlossen ist.

3. Verfahren nach Anspruch 1 oder 2, bei dem das isolierende Substrat (1) ein keramisches Substrat ist.

4. Verfahren nach Anspruch 1 oder 2, bei dem das isolierende Substrat (1) ein Aluminiumoxidsubstrat ist.

5. Verfahren nach Anspruch 1 oder 2, bei dem das isolierende Substrat (1) ein Glassubstrat ist.

## Revendications

1. Procédé de fabrication d'un élément à couche épaisse, comportant le fait de former par adhérence en utilisant la sérigraphie, sur une surface principale plate d'un substrat isolant (1), premièrement une pluralité d'électrodes, constituées par au moins une paire de conducteurs (2a, 2b) espacés l'un de l'autre, puis au moins une couche résistante électrique (3), qui, ou dont chacune, s'étend d'un conducteur (2a) à l'autre (2b) et est électriquement reliée auxdits conducteurs (2a, 2b), caractérisé par le fait que les portions d'extrémité de ladite couche résistante électrique (3) recouvrent respectivement lesdits conducteurs (2a, 2b) sur une distance (p) d'environ 0,1 mm et que lesdits conducteurs (2a, 2b) ont une épaisseur non supérieure à 5 µm, de sorte que les surfaces desdits conducteurs (2a, 2b) et de ladite couche résistance électrique (3), y compris les portions d'extrémité, en recouvrement, de la couche résistante électrique sont plates.

2. Procédé selon la revendication 1, dans lequel une pluralité desdites paires de conducteurs (2a, 2b) sont formées par adhérence à la façon d'une matrice et dans lequel ladite couche résistante électrique plate (3) est l'une d'une pluralité de telles couches, chacune électriquement reliée aux conducteurs d'une paire de conducteurs respective (2a, 2b).

3. Procédé selon la revendication 1 ou 2, dans lequel ledit substrat isolant (1) est un substrat de céramique.

4. Procédé selon la revendication 1 ou 2, dans lequel ledit substrat isolant (1) est un substrat d'alumine.

5. Procédé selon la revendication 1 ou 2, dans lequel ledit substrat isolant (1) est un substrat de verre.
